(19) Europäisches Patentamt
European Patent Office
Office européen des brevets

(11) Publication number: 0 117 626 A2

(12) **EUROPEAN PATENT APPLICATION**

(21) Application number: 84300465.6

(22) Date of filing: 26.01.84

(51) Int. Cl.³: H 03 H 21/00

(30) Priority: 04.02.83 US 464029
04.02.83 US 464054

(43) Date of publication of application: 05.09.84 Bulletin 84/36

(84) Designated Contracting States: DE FR GB NL SE



(71) Applicant: Western Electric Company, Incorporated, 222 Broadway, New York, NY 10038 (US)

(72) Inventor: Gritton, Charles William Kevin, 209 Bishop Blvd., North Brunswick New Jersey 08902 (US)
Inventor: Boyer, Kim Laverne, 8629 Discovery Blvd., Walkersville Maryland 21793 (US)

(74) Representative: Buckley, Christopher Simon Thirsk et al, Western Electric Company Limited 5 Mornington Road, Woodford Green Essex IG8 0TU (GB)


(54) **Improvements in or relating to adaptive filter arrangements.**


(57) An extended impulse response characterisitic is obtained by connecting a plurality of adaptive filters (101) or echo cancelers in a tandem connection. Delay units (102) are associated with receive inputs (X) of the adaptive filters or echo cancelers so that each filter or canceler models a predetermined fixed portion of the extended impulse response characteristic. The relative positions of the filters or cancelers in the tandem connection are controllably switched [via 103–0 to 103–(N–1) and (104)] at a predetermined rate (via 105) to ensure so-called 'good' adaptation of the individual adaptive filters or echo cancelers. The adaptive filter or echo canceler in a preferred position in the tandem connection may be allowed to adapt at its normal rate while the other filters or cancelers are inhibited (via $\overline{INH}$) from adapting, or are allowed to adapt at slower rates dependent on their relative positions in the tandem connection.


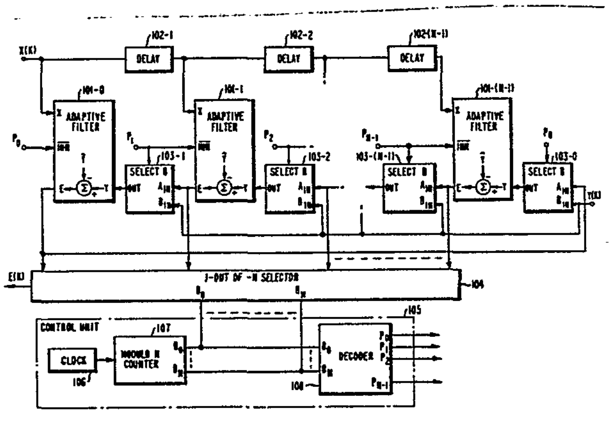


EP 0 117 626 A2

(K.L.Boyer 1-4)

# IMPROVEMENTS IN OR RELATING TO ADAPTIVE FILTER ARRANGEMENTS

This invention relates to adaptive filter arrangements.

Adaptive filters operate on an incoming signal to generate an impulse response characteristic in accordance with a prescribed algorithm. Existing adaptive filters, for example, those used as echo cancelers, are able to model an impulse response of a limited interval, for example, 16 milliseconds. In some applications, it is desirable to model an impulse response having an interval greater than the available interval of an individual adaptive filter or echo canceler. One example is in applications where the round trip electrical delay encountered in a telephone transmission channel is greater than the impulse response interval of an individual echo canceler. Another example is in applications for addressing acoustic delays where the impulse response needed can be extremely long.

One solution to the long electrical delay problem is to use a "truly" cascadable adaptive filter or echo canceler. In such an arrangement, each filter or canceler uses a common error signal to update the impulse response estimate being generated. In order to do this, the individual adaptive filters or cancelers must be arranged to facilitate inputting the common error signal to the impulse response updating circuitry. Moreover, only a limited number of these truly cascadable echo cancelers can be cascaded and, therefore, their use is essentially limited to addressing the long electrical delays and not the extremely long acoustic delays.

According to this invention an adaptive filter arrangement includes a first and at least a second adaptive filter arranged in tandem, and means for controllably switching the relative positions of the adaptive filters in their tandem relationship to obtain an extended impulse response.

In one embodiment a first adaptive filter or echo canceler arranged to generate a first portion of the extended impulse response interval is switchably connected in tandem with at least a second adaptive filter or echo canceler arranged to generate a second portion of the extended impulse response interval. A switching control circuit is employed to control switching of the relative positions of the adaptive filters or echo cancelers in the tandem connection in accordance with prescribed criteria. The first adaptive filter or echo canceler may be initially connected in a first so-called preferred position in the tandem connection and the at least second adaptive filter or echo canceler including a predetermined fixed delay in its receive side connected in a second position in the tandem connection. A received signal is supplied to the receive side of the first adaptive filter or echo canceler and via the delay to the receive side of the at least second adaptive filter or echo canceler, while a transmit signal is first supplied to a transit input of the at least second adaptive filter or echo canceler and a transmit output signal from the at least second adaptive filter or echo canceler is supplied to a transmit input of the first adaptive filter or echo canceler. A transmit output signal from the first adaptive filter or echo canceler is the initial filter or echo canceler output. Initially, both adaptive filters or echo cancelers are adapting. Upon detection of prescribed filter or canceler output signal conditions the relative positions of the adaptive filters or echo cancelers are controllably reversed, i.e. the at least second adaptive filter or echo canceler including the delay is switched to the preferred position, and the first adaptive filter or echo canceler is inhibited from further adapting and is switched to the second position in the tandem connection. The at least second adaptive filter or echo canceler is allowed to continue adapting.

In another embodiment of the invention an extended impulse response characteristic is obtained by

switchably connecting a plurality of adaptive filters or echo cancelers in tandem, the relative positions of the individual adaptive filters or cancelers in the tandem connection being switched so that each of the adaptive filters or cancelers is connected in a prescribed sequence in a so-called preferred position in the tandem connection. The adaptive filter or canceler in the preferred position may be enabled to adapt at a so-called normal rate while the adaptation rates of the other adaptive filters or cancelers may be controllably set to predetermined rates less than the normal rate of adaptation. The relative positions of the adaptive filters or canceler in the tandem connection may be switched continuously at a predetermined rate. The adaptive filter or canceler in the preferred position may be enabled to adapt at the normal rate while the other adaptive filters or cancelers are inhibited from adapting. The adaptive filter or canceler in the preferred position may be enabled to adapt at the normal rate while the other adaptive filters or cancelers are controlled to adapt at predetermined rates less than the normal rate determined in accordance with the relative positions of the individual adaptive filters or cancelers in the tandem connection.

The plurality of adaptive filters or cancelers may be switchably connected in a so-called ring configuration and each of the adaptive filters or cancelers may have a predetermined delay associated with a receive input so that each adaptive filter or canceler models a different portion of the desired extended impulse response characteristic. A zero delay is typically associated with one of the adaptive filters or cancelers. Transmit inputs and outputs of the adaptive filters or cancelers may be switchably connected so that the relative positions of the adaptive filters in the ring configuration are controllably switched in a prescribed sequence at a predetermined rate while the portion of the extended impulse response characteristic that each filter or canceler models remains fixed. The adaptive filter or

canceler in the so-called preferred position of the ring configuration may be enabled to adapt at a normal rate while the other adaptive filters or cancelers may be either inhibited from adapting or permitted to adapt at rates less than the normal rate determined in accordance with the relative position of the adaptive filter or canceler in the ring configuration. The ring configuration may be such that a received signal is supplied via the delay units to receive inputs of the adaptive filters or cancelers while a transmit signal is supplied to the transmit input of the "last" adaptive filter or canceler in the ring configuration. An output from a transmit output of the last filter or canceler is supplied to the transmit input of the next to last filter or canceler in the ring configuration and so on until the signal to be transmitted, i.e. the adaptive filter or echo canceler error signal, is outputted from a transmit output of the first filter or canceler, i.e. the filter or canceler in the preferred position, in the ring configuration.

The invention will now be described by way of example with reference to the accompanying drawings, in which:

FIG. 1 shows in simplified block diagram form a tandem connection of adaptive filters or echo cancelers embodying the invention;

FIG. 2 depicts in simplified block diagram form details of the control unit in the embodiment of FIG. 1;

FIG. 3 shows in simplified block diagram form another tandem connection of adaptive filters or echo cancelers embodying the invention; and

FIG. 4 shows in simplified block diagram form yet another tandem connection of adaptive filters or echo cancelers embodying the invention.

Referring now to FIG. 1, a received signal X(k) is supplied to receive input X of

adaptive filter 10 and via delay unit 11 to receive input X of adaptive filter 12. Adaptive filters 10 and 12 may be any one of a number known in the art. In this example, adaptive filters 10 and 12 are echo cancelers each including an adaptive transversal filter and are of a type broadly disclosed in U. S. patent 3,500,000 and described in an article by D. L. Duttweiler and Y. S. Chen entitled, "A Single-Chip VLSI Echo Canceler", The Bell System Technical Journal, Vol. 59, No. 2, February 1980, pages 149-160. Briefly, each of adaptive filters 10 and 12 has a receive input (X), transmit input (Y), transmit output (E), and update inhibit input ($\overline{INH}$). The adaptive filters (echo cancelers) operate in known fashion to generate a signal estimate $\hat{Y}$ which is algebraically combined with a signal supplied to transmit input Y to generate an error signal at the transmit output E. The error signal is used internally in the adaptive filter or echo canceler to update filter tap coefficient values in order to better model the impulse response characteristic being generated and drive the error signal toward a zero value.

Delay unit 11 is employed to fix the portion of the desired extended impulse response characteristic generated by each of adaptive filters 10 and 12. The delay interval of delay unit 11 is dependent on the number of coefficient taps (Z) in adaptive filter 10 and the sampling interval k being employed. Typically, delay unit 11 includes a shift register having Z stages which is clocked at the sampling rate $k^{-1}$. In one example, the number of taps (Z) is 128 and the sample rate ($k^{-1}$) is 8kHz. Thus, adaptive filter 10 typically has a zero delay and models a first fixed portion of the extended impulse response, for example, a 16 millisecond interval and adaptive filter 12 has delay unit 11 associated with its receive input (X) and, consequently, models a second fixed portion of the extended impulse response characteristic, for example, an interval from 16 to 32 milliseconds.

Adaptive filters 10 and 12 are switchably connected in a tandem connection via controllable selector units 13, 14 and 15. As shown, the transmit output (E) of adaptive filter 10 is connected to the $A_{IN}$ input of selector unit 13 and to the $B_{IN}$ input of selector unit 15. Similarly, the transmit output (E) of adaptive filter 12 is connected to the $A_{IN}$ input of selector unit 14 and to the $B_{IN}$ input of selector 13. A signal to be transmitted, for example, Y(k), is supplied to the $A_{IN}$ input of selector unit 15, to the $B_{IN}$ input of selector unit 14 and to control unit 16. Signal Y(k) is, for example, an outgoing signal to be transmitted in an echo canceler application including near-end speech and the echo signal to be cancelled or an arbitrary system signal in an adaptive filter application. An output from selector unit 15 is supplied to transmit input Y of adaptive filter 12. Similarly, an output from selector unit 14 is connected to transmit input Y of adaptive filter 10. An output from selector unit 13 is connected to control unit 16 and is the desired transmit output or error signal E(k). The output from each of selector units 13, 14 and 15 is normally the $A_{IN}$ input and is the $B_{IN}$ input when enabled by a true, i.e., logical 1, switch control signal SW being supplied to the select B input from control unit 16.

Control unit 16 operates to generate switch control signal SW for controllably switching the relative positions of adaptive filters 10 and 12 in the tandem connection. Control unit 16 in response to an ON-HOOK to OFF-HOOK transition indicating initiation of a call generates a false, i.e., logical 0, switch control signal SW. Upon a prescribed relationship between error signal E(k) and transmit input signal Y(k) occurring control unit 16 generates a true, i.e., logical 1, switch control signal SW. In one example, control unit 16 compares the error signal E(k) power to the transmit input signal Y(k)

power to obtain a measure of the tandem adaptive filter "advantage". Specifically, a scaled version of the transmit input signal power is compared to the error signal power and when the error signal power becomes less than the scaled transmit input signal power the adaptive filter in a preferred position in the tandem connection, initially adaptive filter 10, is assumed to be converged. At this instant, control unit 16 generates a true, i.e., logical 1, SW signal. Consequently, the relative positions of adaptive filters 10 and 12 are controllably switched, in accordance with an aspect of the invention, in the tandem connection and adaptive filter 10 is inhibited from further adapting. This is realized by selector units 13, 14 and 15 being controlled via signal SW to select input $B_{IN}$ as their outputs and by adaptive filter 10 being inhibited by signal SW. Thus, transmit input signal Y(k) is supplied to transmit input Y of adaptive filter 10, transmit output E of adaptive filter 10 is supplied to transmit input Y of adaptive filter 12 and transmit output E of adaptive filter 12 is error signal E(k).

The reason for switching of the positions of adaptive filters 10 and 12 is to minimize the affect of noise generated by the adaptive filters on their convergence. It has been determined that the adaptive filter in a so-called preferred position in the tandem connection will converge relatively well and cause relatively small amounts of unwanted noise. In this example, adaptive filter 10 is initially in the preferred tandem connection position. Since adaptive filter 10 converges relatively well, it then can be frozen, i.e., inhibited from further adapting, and switched to the other position in the connection while adaptive filter 12 is switched to the preferred position and is allowed to adapt. Since adaptive filter 12 is now in the preferred position, it will converge relatively well and the misalignment noise introduced by adaptive filters 10 and

12 is minimized.

FIG. 2 shows in simplified block diagram form details of control unit 16. Accordingly, shown are power value measurement units 20 and 21, amplifier 22, comparator 23 and set-reset flip-flop 24. Transmit input signal Y(k) is supplied to power value measurement unit 20 which generates an output $Y_p(k)$ representative of the power of Y(k). Similarly, error signal E(k) is supplied to power value measurement unit 21 which generates an output $E_p(k)$ representative of the power of E(k). Power value measurement units 20 and 21 are reset in response to an ON-HOOK - OFF-HOOK transition. Signal $Y_p(k)$ is supplied via scaling amplifier 22 to one input of comparator 23 while signal $E_p(k)$ is supplied to another input of comparator 23. The output from comparator 23 is negative, i.e., representative of a logical 0, until $E_p(k) < \alpha Y_p(k)$. When $E_p(k)$ becomes less than $\alpha Y_p(k)$ initial convergence of adaptive filter 10 (FIG. 1) is assumed to be complete and comparator 23 yields a positive output, i.e., representative of a logical 1. To this end, scaling factor $\alpha$ is the expected echo return loss enhancement factor, i.e., the adaptive filter transmit input power less the adaptive filter output power after, for example, echo cancellation in an echo canceler application. In one example of an echo canceler application, $\alpha$ is 20 dB power. An output from comparator 23 is supplied to a set (S) input of flip-flop 24 when the ON-HOOK - OFF-HOOK signal is supplied to a reset (R) input of flip-flop 24. In operation, flip-flop 24 is reset by an ON-HOOK - OFF-HOOK transition to generate a false, i.e., logical 0, SW signal at output Q. Then, when $E_p(k)$ becomes less than $\alpha Y_p(k)$ flip-flop 24 is set by a logical 1 output from scaling amplifier 23 to generate a true, i.e., logical 1 SW signal at output Q.

Each of power measurement units 20 and 21 includes apparatus (not shown) for squaring the supplied input sample values and a low pass filter for obtaining

0117626

smooth versions of the desired power measurement values in well known fashion.

One problem with this arrangement is that it must be determined when to switch the filters or cancelers. Another problem is that ON-HOOK, OFF-HOOK information is needed to initiate and reset the filter or canceler adaptation process. This type of information is not usually available for echo canceler applications. Moreover, because of the need to determine when to switch the filters or cancelers, this arrangement is not readily expanded beyond the two adaptive filters or echo canceler applications. Thus, although this tandem arrangement may be satisfactory for some applications, it is not for others, for example, the canceling of acoustic echo and where ON-HOOK, OFF-HOOK information is not readily available.

Referring now to FIG. 3, a received signal X(K) is supplied to a receive input (X) of adaptive filter 101-0 and via delay units 102-1 to 102-(N-1) to receive inputs X of adaptive filters 101-1 to 101-(N-1), respectively. Adaptive filters 101 may be any one of a number known in the art. In this example, adaptive filters 101 are echo cancelers each including an

adaptive transversal filter and are of a type broadly disclosed in U. S. patent 3,500,000 and described in an article by D. L. Duttweiler and Y. S. Chen entitled, "A Single-Chip VLSI Echo Canceler", The Bell System Technical Journal, Vol. 59, No. 2, February 1980, pages 149-160. Briefly, each of adaptive filters 101 has a receive input (X), transmit input (Y), a transmit output (E), update inhibit input ($\overline{INH}$) or an update gain adjustment input (GAIN) (see FIG. 2). The adaptive filters (echo cancelers) operate in known fashion to generate a signal estimate $\hat{Y}$ which is algebraically combined with a signal supplied to transmit input Y to generate an error signal at the transmit output E. The error signal is used internally in the adaptive filter or echo canceler to update the tap coefficient values in order to better model the impulse response characteristic being generated and drive the error signal toward a zero value.

Delay units 102-1 to 102-(N-1) are employed to fix the portion of the desired extended impulse response characteristic that each of adaptive filters 101-0 to 101-(N-1) generates. The delay interval of each of delay units 102 is dependent on the number of coefficient taps (Z) in adaptive filters 101 and the sampling interval K being employed. Typically, each of delay units 102 includes a shift register having Z stages and being clocked at the sampling rate $K^{-1}$. In one example, the number of taps (Z) is 128 and the sampling rate ($K^{-1}$) is 8kHz. Thus, adaptive filter 101-0 typically has a zero delay and models a first fixed portion of the extended impulse response, for example, a 16 millisecond interval. Adaptive filter 101-1 has one delay unit, namely, delay 102-1, associated with its receive input (X) and, consequently, models a second fixed portion of the extended impulse response characteristic, for example, an interval from 16 to 32 milliseconds. The next one of adaptive filters, namely 101-2, in the tandem connection has two of delay units 102 associated with its receive

input and generates a third fixed portion of the extended impulse response and so on to the last adaptive filter, namely 101-(N-1) in the tandem connection which has (N-1) delay units associated with its receive input and models an $N^{th}$ fixed portion of the extended impulse response characteristic.

Adaptive filters 101-0 to 101-(N-1) are switchably connected in a so-called ring configuration via controllable selector units 103-0 to 103-(N-1) and 1-out of-N selector unit 104. As shown, the transmit output (E) of each of adaptive filters 101-0 to 101-(N-1) is connected to the $A_{IN}$ input of an associated one of selector units 103-0 to 103-(N-1), respectively, and to 1-out of-N selector unit 104. A signal to be transmitted, for example, Y(K), is supplied to a $B_{IN}$ input of each of selector units 103-0 to 103-(N-1). Signal Y(K) is, for example, the signal to be transmitted in an echo canceler application including near-end speech and the echo signal to be cancelled or an arbitrary system signal in an adaptive filter application. The output from each of selector units 103-0 to 103-(N-1) is normally the $A_{IN}$ input and is the $B_{IN}$ input when enabled by a true, i.e., logical 1, signal being supplied to the select B input from control unit 105.

Selector units 103 as shown assume no delay in the transmit input to transmit output path in adaptive filters 101. If there are delays in the transmit input to transmit and output path, appropriate delays need to be included in 1-out of-N selector unit 104 and selector units 103 to eliminate any resulting transients caused by instantaneously switching the relative positions of adaptive filters 101 in the tandem connection.

Control unit 105 operates to generate signals for controlling the sequential switching at a continuous predetermined rate of the relative positions of adaptive filters 101-0 to 101-(N-1) in the tandem connection. To this end, control unit 105 includes clock 106, modulo N

counter 107 and decoder 108. Clock 106 generates a clock signal at a predetermined rate, for example, at a 10Hz rate. The clock signal is supplied to modulo N counter 107 which, in turn, generates binary output bits $B_0$ to $B_M$ which are representative of binary 0 to (N-1) in sequence at the predetermined clock rate. In one example, when the invention is employed to cancel a long electrical echo, N equals 4 and M equals 1. In another example, when the invention is employed to cancel an acoustic echo, N equals 8 and M equals 2. Binary bits $B_0$ to $B_M$ are supplied to 1-out of-N selector 104 for controlling which one of the transmit outputs (E) of adaptive filters 101 is to be outputted as the desired tandem adaptive filter output E(K) in the prescribed sequence at the predetermined clock rate. Binary bits $B_0$ to $B_M$ are also supplied to decoder 108 which, in turn, generates control signals $P_0$ to $P_{N-1}$. Decoder 108 is operative to generate a true output, i.e., representative of a logical 1, in sequence at outputs $P_0$ to $P_{N-1}$ at the predetermined continuous rate. Only one of outputs $P_0$ to $P_{N-1}$ is true at any instant while the remaining outputs are false, i.e., representative of a logic 0. Outputs $P_0$ to $P_{N-1}$ are supplied to the inhibit inputs (INH) of adaptive filters 101-(N-1), respectively, and to the select B inputs of selector units 103-0 to 103-(N-1), respectively. Since only one of control signals $P_0$ to $P_{N-1}$ is true during any clock interval; only one of adaptive filters 101 is enabled to adapt while the others of adaptive filters 101 are inhibited from adapting. Additionally, the enabled one of adaptive filters 101 is connected in a so-called preferred position, i.e., a first position, in the tandem connection by the corresponding one of selector units 103 being enabled to supply transmit signal Y(K) to the transmit input (Y) of the last one of adaptive filters 101

in the tandem connection. Also 1-out of-N selector 104 in response to binary bits $B_0$ - $B_M$ selects the transmit output (E) of the one of adaptive filters 101 in the first position as output E(K).

By way of example, in a given clock interval assume $P_0$ is true and corresponding binary bits $B_0$ - $B_M$ are representative of binary 0. Then, adaptive filter 101-0 is enabled to adapt at a so-called normal rate while the other adaptive filters, namely, 101-1 to 101-(N-1) are inhibited from adapting, and transmit output E from adaptive filter 101-0 is selected by selector 104 as output E(K). The normal rate of adaption is a rate obtained by setting the tap coefficient update gain value so that good quality adaption would result if the adaptive filter or echo canceler was being used in a non-tandem application. In one example, the normal rate of adaption is set at -50 dB/second. That is to say, the decreasing slope of error signal E of adaptive filters 101 during the initial portion of the adaptation process is 50 dB/second in power. Selector unit 103-0 is also enabled via $P_0$ to supply Y(K) to the transmit input (Y) of the last adaptive filter in the tandem connection, namely, 101-(N-1). Additionally, the transmit output E from adaptive filter 101-(N-1) is supplied via selector unit 103-(N-1) to the transmit input of the next to last one of adaptive filters 101 in the tandem connection, namely, 101-(N-2) and so on until the transmit signal modified by filters 101-1 to 101-(N-1) is supplied to the transmit input of the first adaptive filter in the tandem connection, namely, 101-0. During the next clock interval $P_1$ is true and binary bits $B_0$ - $B_M$ are representative of binary 1 and, consequently, adaptive filter 101-1 is switched to the first or preferred position in the tandem connection and adaptive filter 101-0 is switched to the last position in the tandem connection. Thus, the relative positions of adaptive filters 101 in the tandem connection are controllably

switched in the prescribed sequence and at the predetermined continuous rate so that each one of adaptive filters 101 is connected in the first or preferred position in the prescribed sequence. It is noted that since the switching occurs in the transmit inputs and outputs of adaptive filters 101 and since delay units 102 are connected in circuit relationship with the filter receive inputs, the portion of the desired extended impulse response that each of adaptive filters 101-0 through 101-(N-1) models remains fixed. Furthermore, since each of adaptive filters 101-0 to 101-(N-1) including its corresponding receive input delay is switched to the first position in the connection, it is ensured that the impulse response being modeled will correspond to the arbitrary system or that an appropriate estimate of either an electrical or acoustic echo signal to be cancelled will be generated.

Again, the reason for switching the relative positions of adaptive filters 101-0 to 101-(N-1) in the tandem connection is to ensure "good" adaptation of the individual ones of adaptive filters 101 and, thereby, minimizing so-called misalignment noise from corrupting the resulting error signal E from each filter. To this end, it is noted that the quality of adaptation of each of adaptive filters 101 is dependent on the relative portion of error signal E that can be estimated by the adaptive filter. If the error signal or a portion thereof is within the portion of the extended impulse response being modeled by the filter, "good" adaptation results and there is little so-called misalignment noise in error signal E. However, if none of the error signal is caused by the portion of the impulse response being modeled by the particular filter, then the error estimate being generated will be noisy, i.e., there is a greater amount of misalignment noise generated. Misalignment noise is the noise on the impulse response estimate being generated which is reflected in the error signal E after the output

signal estimate $\hat{Y}$ is subtracted from output signal Y. Allowing the individual ones of adaptive filters 101 to adapt only when in the preferred position minimizes the affect of the noise on the overall adaptation process.

FIG. 4 shows in simplified block diagram form another embodiment of the invention. The embodiment of FIG. 4 is similar to the embodiment of FIG. 3 . Accordingly, elements in the embodiment of FIG. 4 which are identical to those in FIG. 3 have been similarly numbered and will not be discussed again in detail. Indeed, operation of the embodiment of FIG.4 is identical to that discussed above regarding the continuous switching at the predetermined rate and in the prescribed sequence of the relative positions of adaptive filters 201-0 to 201-(N-1) in the tandem connection. The difference between the embodiments of FIG.3 and FIG.4 is that instead of inhibiting the adaptation of all of adaptive filters 201 except the one in the preferred or first position in the tandem connection, the ones of adaptive filters 201 not in the preferred position are allowed to adapt but at a predetermined rate typically slower than the normal adaption rate and determined by the relative positions of the adaptive filters in the tandem connection.

This is realized by controlling the tap coefficient update gain via control signals $G_0$ to - - $G_{N-1}$ generated by gain selection unit 209 in control unit 205. The reason for the varied update gains is that the adaptive filter in the second or next to the preferred position in the tandem connection is only slightly "less preferred" than the adaptive filter in the preferred or first position and so on to the last adaptive filter in the tandem connection. Consequently, in some applications, it is preferable to let the "less preferred" adaptive filters still adapt but at a rate slower than the normal or preferred rate rather than inhibiting adaptation entirely. Since some adaptive filters and echo cancelers have

selectable update gain, this implementation is readily realizable. To this end, gain control signals $G_0$ to $G_{N-1}$ are supplied from control unit 205 to the GAIN inputs of adaptive filters 201-0 to 201-(N-1), respectively. As indicated above the normal rate of adaption is a rate obtained by setting the tap coefficient update gain value so that good quality adaption would result if the adaptive filter or echo canceler was being used in a non-tandem application. As indicated above, one example of a normal adaptation rate is -50 dB/second.

The gains of adaptive filters 201-0 to 201-(N-1) are controlled in one example by letting G be the normal update gain value. Then, the gain of the adaptive filter in the preferred position is controlled to be a value G which yields the so-called normal rate of adaption. Then, the gain of the adaptive filter next in the tandem connection is controlled to be G/2 and so on until the last adaptive filter has a gain of G/N. This gain control is realized by employing a read-only-memory for gain selection unit 209 programmed to output the appropriate gain control values $G_0$ to $G_{N-1}$ in a prescribed sequence in response to binary bits $B_0$ to $B_M$ from modulo N counter 107. Specifically, letting $G_i$ be the gain value for adaptive filter i in the tandem connection (i=0, 1, 2, ..., N-1) G being the normal gain for the adaptive filter in the preferred position and j being the preferred adaptive filter position, then

$$G_i = \left\lfloor \frac{G}{[(i-j) \text{ modulo } N] + 1} \right\rfloor$$

where the symbol $\lfloor \ \rfloor$ is the so-called floor function applied to the function L (within the symbol) and yields the smallest integer less than or equal to the function L.

The above arrangements are only examples of the invention. It will be apparent to

those skilled in the art that various changes in form and detail may be made. Indeed, in Figs 3 and 4 the adaptive filters or echo cancelers need not be switched continuously; a number of iterations may only be required. Additionally, echo cancelers may be substituted for the adaptive filters as indicated. For example, the 140AB or 140Y echo canceler manufactured by Western Electric Company may be employed as adaptive filters 101 (FIG. 3) and the 257U or 257AC echo cancelers also manufactured by Western Electric Company may be employed as adaptive filters 201 (FIG. 4).

CLAIMS

1. An adaptive filter arrangement including a first (101-0) and at least a second (101-1) adaptive filter arranged in tandem, CHARACTERISED BY means (103,105) for controllably switching the relative positions of said adaptive filters in their tandem relationship to obtain an extended impulse response.

2. An arrangement as claimed in claim 1 wherein the first adaptive filter is adapted to generate a first predetermined portion of the extended impulse response and the second adaptive filter is adapted to generate a second predetermined portion of the extended impulse response.

3. An arrangement as claimed in claim 1 or 2 wherein the switching means includes means (105) for switching the relative positions of the adaptive filters at a predetermined rate.

4. An arrangement as claimed in claim 3 wherein the switching means includes means (106,107,108) for continuously switching the relative positions of the adaptive filters in a prescribed sequence at the predetermined rate.

5. An arrangement as claimed in any preceding claim including means ($\overline{INH}$) responsive to control signals for inhibiting adaptation of the adaptive filters, and wherein the switching means includes means (108) for generating the control signals to enable adaptation of one of the adaptive filters in a predetermined position in the tandem connection and to disable adaptation of the or each other adaptive filter in the tandem connection.

6. An arrangement as claimed in any preceding claim including means (GAIN) responsive to control signals for controlling the rate of adaptation of the adaptive filters, and wherein the switching means includes means (209) for generating the control signalsto control the adaptation rates of the adaptive filters in accordance with their relative positions in the tandem connection.

7. An arrangement as claimed in claim 6 wherein

the adaptation rate controlling means includes means responsive to the control signal for controllably adjusting the tap coefficient update gain of the adaptive filters, and the switching means includes means for generating the update gain control signals in accordance with prescribed criteria dependent on the relative positions of the adaptive filters in the tandem connection.

8. An arrangement as claimed in claim 7 wherein there are more than two adaptive filters in the tandem connection, the update gain control signals are generated so that the update gain of the adaptive filter in a predetermined position in the tandem connection is adjusted so that it adapts at a normal rate and the update gains of the other adaptive filters are adjusted so that they adapt at predetermined rates slower than the normal rate and determined in accordance with their relative positions in the tandem connection.

CSTB/KW.

FIG.1

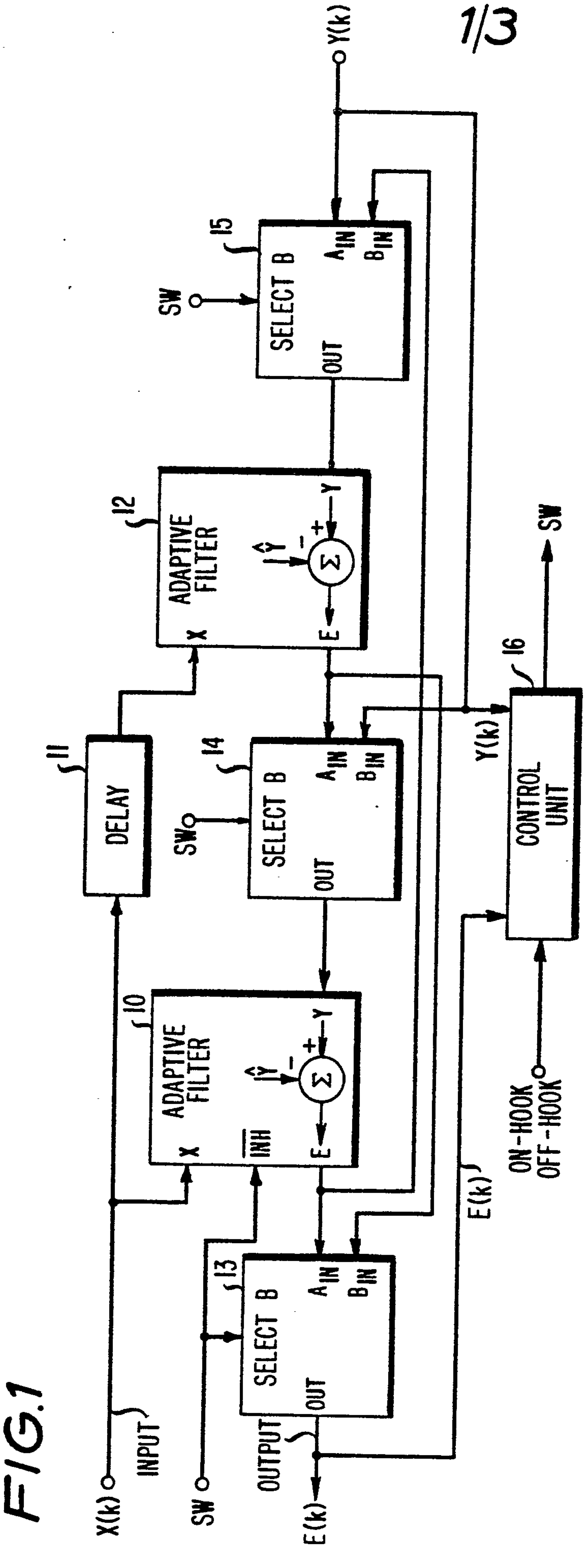
Y(k)
15
SELECT B
SW
$A_{IN}$
$B_{IN}$
OUT
12
ADAPTIVE FILTER
$\hat{Y}$
Σ
Y
E
X
11
DELAY
14
SELECT B
SW
16
CONTROL UNIT
SW
Y(k)
10
ADAPTIVE FILTER
$\overline{INH}$
13
SELECT B
E(k)
ON-HOOK
OFF-HOOK
X(k)
INPUT
OUTPUT
E(k)

FIG.2

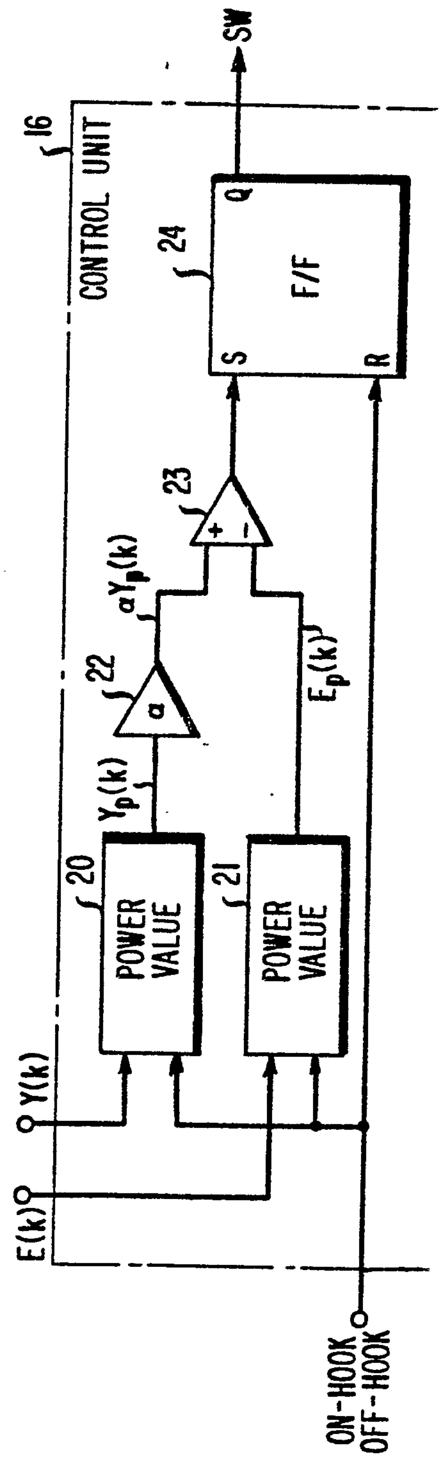
16
CONTROL UNIT
SW
24
F/F
S
R
Q
23
+
−
$\alpha Y_p(k)$
22
α
$E_p(k)$
$Y_p(k)$
20
POWER VALUE
21
POWER VALUE
Y(k)
E(k)
ON-HOOK
OFF-HOOK

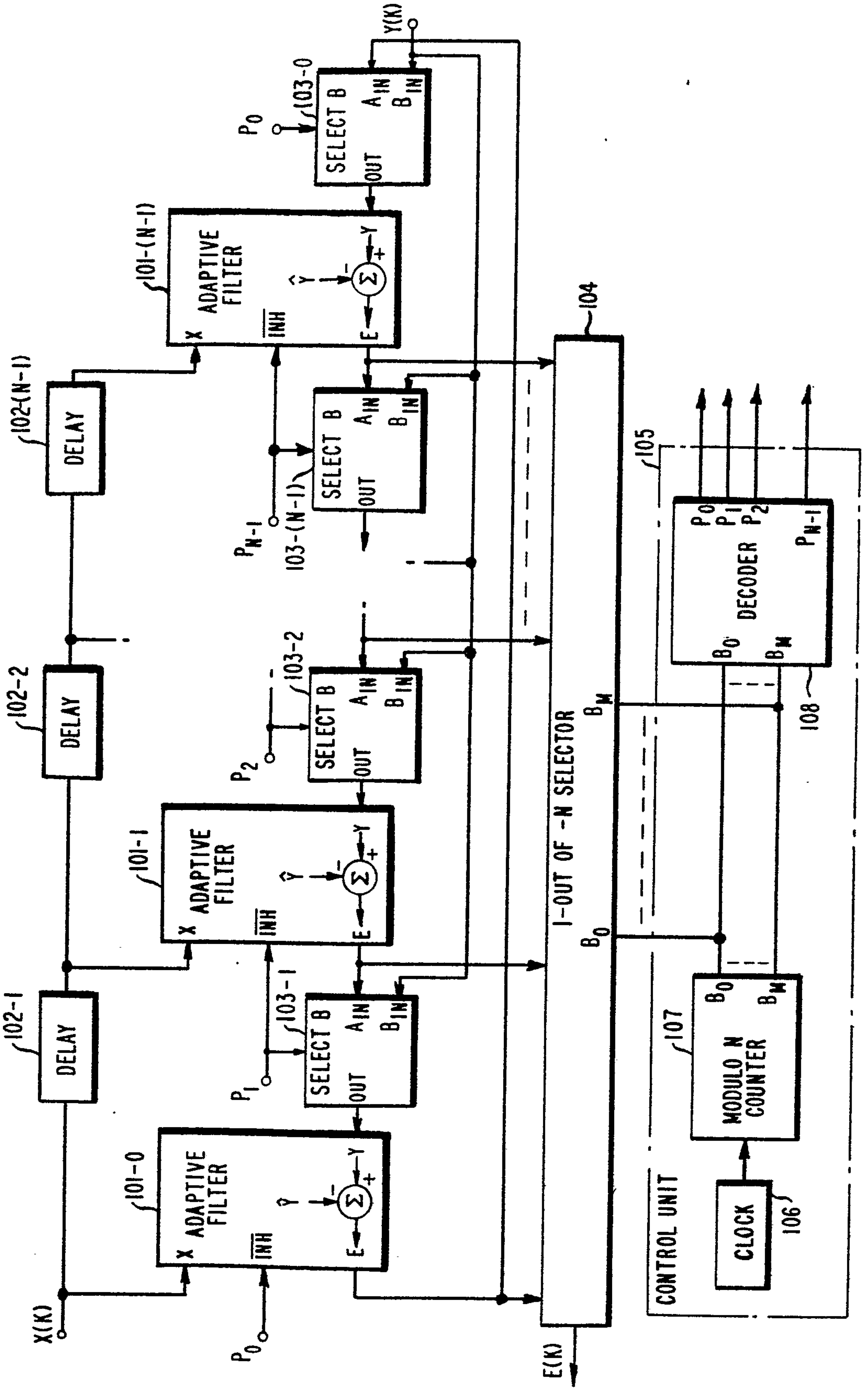
X(K)
Y(K)
E(K)
P0
P1
P2
PN-1
DELAY
102-1
102-2
102-(N-1)
ADAPTIVE FILTER
101-0
101-1
101-(N-1)
X
INH
E
Y
SELECT B
OUT
AIN
BIN
103-0
103-1
103-2
103-(N-1)
1-OUT OF -N SELECTOR
104
B0
BM
105
DECODER
108
MODULO N COUNTER
107
CLOCK
106
CONTROL UNIT

FIG.3

FIG. 4

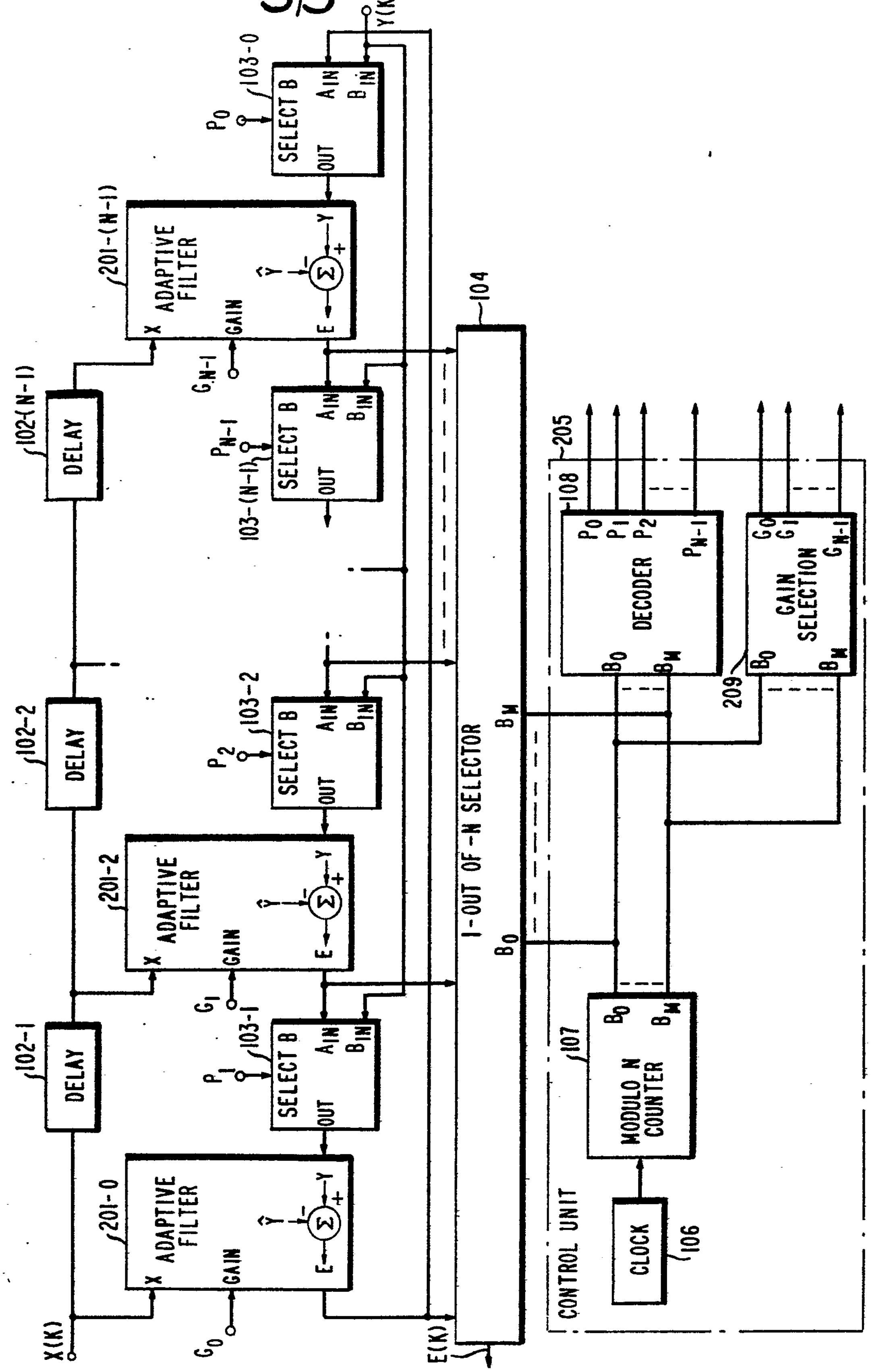
X(K)
Y(K)
E(K)
DELAY
102-1
102-2
102-(N-1)
ADAPTIVE FILTER
201-0
201-2
201-(N-1)
X
GAIN
E
Y
G0
G1
GN-1
SELECT B
OUT
AIN
BIN
103-0
103-1
103-2
103-(N-1)
P0
P1
P2
PN-1
1-OUT OF-N SELECTOR
104
B0
BM
DECODER
108
P0
P1
P2
PN-1
GAIN SELECTION
209
G0
G1
GN-1
205
MODULO N COUNTER
107
CLOCK
106
CONTROL UNIT